# EUROPEAN PATENT APPLICATION

(11) **EP 4 800 415 A1**
(43) Date of publication of application: **02.09.2026**
(21) Application number: 25160451.8
(22) Date of filing: 27.02.2025
(51) Int. Cl.: G01R 33/34

(54) **SENSOR FOR A RADIO FREQUENCY COIL**

(71) Applicant: Koninklijke Philips N.V., 5656 AE Eindhoven (NL)
(72) Inventor: SHARMA, Devendra, Eindhoven (NL); PALIWAL, Shyam, Eindhoven (NL)
(74) Representative: Philips Intellectual Property & Standards

(57) **Abstract**

The present invention provides a sensor (11) for a radio frequency coil (1), comprising:
a frame (2),
a mechanical biasing element (3),
a mass (4), and
a mechanical retaining mechanism (5) for holding the mass (4) in a retaining position, wherein
the mechanical biasing element (3) is abutted to the frame (2) and configured to exert a bias force on the mass (4), urging the mass (4) away from its retaining position into a displacement direction, and
the mechanical retaining mechanism (5) is configured to hold the mass (4) in the retaining position against the bias force of the mechanical biasing element (3) and to let the mass (4) displace from the retaining position in the displacement direction into a displacement position when an external force with a force component in the displacement direction exceeding a predetermined threshold is exerted on the mass (4) in addition to the bias force of the mechanical biasing element (3). In this way, a possibility for detecting mishandling of a radio frequency coil (1) in a safe an efficient way is provided.

## Description

### FIELD OF THE INVENTION

The invention relates to a sensor for a radio frequency coil, a sensor arrangement with such sensors, a radio frequency coil with such a sensor or such a sensor arrangement, a magnetic resonance examination system, and a method of operating a magnetic resonance examination system.

### BACKGROUND OF THE INVENTION

Magnetic Resonance (MR) examination systems, and especially Magnetic Resonance Imaging (MRI) systems rely on specialized Radio Frequency (RF) coils to obtain high-quality diagnostic images. These RF coils are portable components designed to be attached and detached from the MRI system depending on the diagnostic requirements and the specific part of the patient's body that needs to be scanned. Various types of coils are available, including head, spine, shoulder, breast, knee, and torso coils, among others. Due to their portable nature, these coils are frequently moved between storage and the MRI system as required. However, this frequent handling exposes them to risks of accidental damage, such as being dropped or impacted by the operator during transport or assembly.

Accidental damage to RF coils is a significant concern as it can lead to mechanical or electronic failures, adversely affecting image quality or rendering the coil inoperative. Analysis of complaints reveals that many reported issues stem from mechanical damage due to mishandling, including instances where coils have been dropped or impacted by other objects. These incidents are often difficult to prevent given the operational requirements and usage style of RF coils. Unfortunately, the effects of mishandling, such as inadequate impact or vibrations, may not always be immediately visible, and undetected damage can accumulate over time, eventually leading to performance degradation or complete failure of the coil.

One major challenge with existing RF coils is the lack of a robust mechanism to detect and record such events when the coil is not connected to the MRI system. Current solutions, such as accelerometers, typically require a continuous power supply to remain active, which is impractical when the coil is being moved or stored. While some coils are equipped with shock indicators, these are limited in functionality, as they cannot detect multiple impacts or provide feedback to the system about the occurrence and severity of mishandling events. As a result, the identification of damage often depends on the operator visually detecting it or reporting it after a performance issue arises, which delays appropriate corrective action.

### SUMMARY OF THE INVENTION

It is an object of the invention to provide a possibility for detecting mishandling of a radio frequency coil in a safe an efficient way.

According to the invention, this object is addressed by the subject matter of the independent claims. Embodiments of the invention are described in the dependent claims.

Therefore, according to the invention, a sensor for a radio frequency coil is provided, comprising:
a frame,
a mechanical biasing element,
a mass, and
a mechanical retaining mechanism for holding the mass in a retaining position, wherein
the mechanical biasing element is abutted to the frame and configured to exert a bias force on the mass, urging the mass away from its retaining position into a displacement direction, and
the mechanical retaining mechanism is configured to hold the mass in the retaining position against the bias force of the mechanical biasing element and to let the mass displace from the retaining position in the displacement direction into a displacement position when an external force with a force component in the displacement direction exceeding a predetermined threshold is exerted on the mass in addition to the bias force of the mechanical biasing element.

Since the mass is held in the displacement position due to the force which is exerted onto the mass by the mechanical biasing element, the invention introduces the possibility of detecting, recording, and reporting any fall or impact events involving RF coils, even when the coil is not connected to a magnetic resonance examination system. This capability is particularly critical for larger and heavier coils, such as head, breast, knee, and shoulder coils, which are more prone to mishandling due to their size and weight. By detecting such events and alerting both the operator and a remote diagnostic team, this invention facilitates immediate action to assess and mitigate potential damage. A remote service diagnostics (RSD) system can perform remote checks for faults or failures, and if necessary, instruct a field service engineer (FSE) to perform further on-site inspections and diagnostics.

This proactive approach not only helps maintain the operational readiness of RF coils but also improves diagnostic reliability by ensuring that damaged coils are identified and repaired before they cause significant imaging issues. Additionally, the ability to record and monitor mishandling events enhances root cause analysis during investigations of customer complaints, thereby saving time and improving service response. Furthermore, the invention includes health checks that can predict potential failures, enabling timely interventions to prevent unsafe or ineffective use of the coils.

Potential failures resulting from mishandling include enclosure damage, which can result in visible cracks or structural issues that may pose a risk of patient injury, and internal mechanical failures, such as broken or dislodged components. Electronic damage, including broken or displaced components, can degrade coil performance and image quality or render the coil entirely non-functional. While preventing such failures may not always be possible, the invention's detection and alert mechanisms ensure that corrective measures can be taken promptly to minimize downtime and improve diagnostic accuracy.

By integrating this fall detection and impact sensing mechanism, the invention significantly enhances the reliability and safety of MR examination systems, ensuring that RF coils remain in good condition and are safe for use during diagnostic procedures.

According to an embodiment of the invention, the sensor further comprises a position detector which is configured for detecting whether the mass has been displaced into the displacement position. This feature provides a critical function by enabling the sensor to reliably detect when an external force, such as an impact or sudden movement, has caused the mass to overcome the bias force and move into the displacement position. The position detector serves as a direct indicator of mishandling events, allowing the sensor to detect even subtle or repeated impacts that may otherwise go unnoticed. Preferably, the detector is configured such that its detector function is activated when the sensor is connected to a MR examination apparatus which may provide electrical energy to the sensor and, therefore, also to the detector. The key advantage of the detector lies in its ability to provide precise feedback on mishandling occurrences. The position detector ensures that any significant impacts can be automatically detected and an alert for an operator may be generated that a manual inspection is necessary. This enhances the overall reliability and efficiency of the system by minimizing the risk of undetected damage, reducing downtime, and ensuring that RF coils remain in optimal working condition. The ability to track mishandling events also supports predictive maintenance, as trends in impact data can help identify coils at risk of future failure, allowing for proactive service interventions.

According to an embodiment of the invention, the sensor further comprises an electrical resetting mechanism which is configured to return the mass from the displacement position into the retaining position against the biasing force after displacement. Once the displacement is detected and the external force subsides, the resetting mechanism ensures that the sensor is reset and ready to detect future events without requiring manual intervention. This automated process eliminates the need for operators to physically access the sensor to reset it, streamlining maintenance and allowing the system to operate with minimal disruption. The key advantage of this embodiment is the improvement in efficiency and operational readiness of the sensor. By enabling automatic resetting, it minimizes delays between successive usage cycles, ensuring that the sensor is continuously available to monitor mishandling events. This is particularly important in clinical settings, where uninterrupted performance of RF coils is critical for reliable diagnostic imaging. The resetting mechanism also reduces the risk of human error, such as forgetting to reset the sensor manually, which could lead to undetected damage during subsequent operations. Furthermore, the automated reset functionality facilitates remote monitoring and control, as the mechanism can be triggered electronically by a connected system or diagnostic platform. This enhances overall system reliability, reduces maintenance efforts, and supports proactive measures to address potential issues before they escalate, thereby improving the longevity and performance of the RF coils.

According to an embodiment of the invention, the electrical resetting mechanism comprises a relay for connecting to and being controlled by a magnetic resonance examination apparatus. The relay acts as a switch, allowing the magnetic resonance system to remotely activate the resetting process and return the mass from its displaced position back to its original retaining position. When the magnetic resonance examination apparatus detects that the sensor needs resetting, it can send a signal to the relay, triggering the resetting mechanism without any need for manual intervention by the operator. The main advantage of this embodiment is the seamless integration between the sensor and the magnetic resonance examination apparatus, which enables automated and remote control of the sensor's resetting function. This eliminates the need for physical access to the sensor, reducing downtime and ensuring that it is always ready for detecting subsequent mishandling events. The relay-controlled mechanism enhances operational efficiency by allowing resets to be performed during routine system checks or maintenance cycles, minimizing disruptions during diagnostic procedures. Additionally, the remote-control capability supports proactive maintenance, as service teams can monitor the sensor's status and initiate resets or diagnostics from a central location. This leads to improved system reliability, reduced service costs, and consistent imaging performance by ensuring that potential damage from mishandling is quickly addressed.

According to an embodiment of the invention, the mass is a ball, and the mechanical retaining mechanism is an annular snap mechanism for holding the ball. The annular snap mechanism creates a secure yet releasable grip around the ball, preventing it from moving under normal conditions while allowing it to displace when an external force exceeding a predetermined threshold is applied. When the ball is subjected to an impact or force in the displacement direction, it overcomes the snap mechanism and moves into its displacement position, triggering the sensor to detect the event. The primary function of this design is to provide a robust and reliable mechanism for detecting mishandling events with minimal complexity. The use of a ball as the mass is advantageous because of its uniform shape, which allows for consistent and predictable displacement behavior. The annular snap mechanism ensures that the ball is securely held until a significant force is applied, reducing the risk of false triggering due to minor vibrations or routine handling. This combination improves the sensor's accuracy in detecting genuine impacts or falls. The advantages of this embodiment include durability and simplicity. The ball and annular snap mechanism are mechanical components that require minimal maintenance and offer long-lasting performance. Their compact design is well-suited for integration into portable RF coils without adding significant weight or complexity. Additionally, the precise retention and displacement mechanism enhance the sensor's ability to distinguish between different levels of force, ensuring that only impactful events are recorded. This improves diagnostic reliability by helping operators or remote systems identify and address potentially damaging incidents promptly.

The ball and/or the mechanical retaining mechanism may be made from brass and/or from a MR compatible plastic material like a polycarbonate or an acetal homopolymer resin (also called polyoxymethylene, POM-H). The mechanical biasing element may be a spring, preferably a spring made of brass. The spring is positioned within the sensor in such a way that it applies a continuous bias force to the mass, urging it away from its retaining position and into the displacement direction. The spring maintains tension under normal conditions, ensuring that the mass remains securely held by the mechanical retaining mechanism until an external force exceeding the threshold is applied. When this force occurs, the spring allows the mass to displace, enabling the sensor to detect the mishandling event. The use of a spring as the biasing element offers several important functional advantages. Springs are simple, reliable mechanical components that provide consistent force over time, ensuring the sensor's performance remains stable even with repeated usage. The spring's mechanical action does not rely on complex electronic systems, which helps reduce power consumption and simplifies the overall design. Additionally, the spring provides precise control over the displacement threshold, allowing the sensor to be fine-tuned for detecting specific impact levels. This improves the accuracy of mishandling detection and ensures that only significant events trigger alerts, reducing false alarms and enhancing the sensor's role in protecting RF coils from undetected damage.

According to an embodiment of the invention, a sensor arrangement with three sensors is provided, wherein the displacement directions of the three sensors all point into different directions. Preferably, the displacement directions of the sensors are all perpendicular to each other, covering three orthogonal axes: X, Y, and Z. This configuration allows the sensor arrangement to detect impacts or forces occurring from any direction in three-dimensional space. Each sensor is sensitive to displacement along its respective axis, ensuring comprehensive coverage and detection of mishandling events regardless of the direction of impact. The primary function of this embodiment is to provide full spatial monitoring, allowing the sensor arrangement to detect falls, shocks, or impacts from any angle. By arranging the sensors perpendicularly, the system ensures that even complex or multi-directional forces, such as those resulting from a coil being dropped or bumped at an angle, are reliably detected. The advantages of this embodiment include enhanced detection accuracy and comprehensive protection of the RF coil. With sensors monitoring different axes, the system can identify the direction and potentially the magnitude of the impact, which is useful for assessing the severity of mishandling events. This multi-directional capability reduces the likelihood of undetected damage and ensures that operators or remote diagnostic systems receive detailed information about mishandling incidents. The arrangement is particularly beneficial for large or heavy RF coils, which may experience varied and unpredictable forces during handling. By covering all directional possibilities, this embodiment improves the overall reliability and effectiveness of the sensor system in protecting the coils and maintaining their operational integrity.

The invention also relates to a radio frequency coil, comprising a sensor or a sensor arrangement as described before.

The invention also relates to a magnetic resonance examination system, comprising a radio frequency coil as described before and a magnetic resonance examination apparatus with a controller for the sensor/sensors of the radio frequency coil.

The invention also relates to method of operating a magnetic resonance examination system comprising a radio frequency coil and a magnetic resonance examination apparatus, wherein
the radio frequency coil comprises a sensor with a mass which is held in a retaining position against a bias force urging the mass away from its retaining position into a displacement direction, wherein the mass is displaced in the displacement direction into a displacement position when an external force with a force component in the displacement direction exceeding a predetermined threshold is exerted on the mass in addition to the bias force,
the method comprising the following method steps:
   sensing whether the radio frequency coil is connected to the magnetic resonance examination system,
   detecting whether the mass is held in the retaining position or was displaced into the displacement position, and
   switching to regular operation of the system when it was detected that the mass is held in the retaining position, or
   switching to a testing procedure when it was detected that the mass was displaced into the displacement position.

The system operates by first sensing whether the radio frequency coil is connected to the magnetic resonance apparatus, ensuring that the sensor's status is monitored only when the coil is in active use. It is detected whether the mass is held securely in its retaining position or has been displaced due to an external force exceeding a predetermined threshold. Depending on the status, the system either switches to regular operation if the mass is in the retaining position, indicating no mishandling, or initiates a testing procedure if the mass has been displaced, indicating a potential impact or mishandling event. The key function of this method is to ensure that the system dynamically assesses the integrity of the RF coil before initiating diagnostic procedures. If a displacement is detected, the testing procedure can include diagnostics to check for potential mechanical or electronic damage to the coil, ensuring it is safe and functional before imaging begins. This approach prevents the use of damaged coils that could degrade image quality or pose safety risks. The advantages of this embodiment include enhanced system reliability, safety, and operational efficiency. By automatically verifying the condition of the RF coil, the system minimizes the risk of undetected damage affecting diagnostic accuracy. The automated testing and switching mechanisms reduce the burden on operators, since electrical and electronic equipment may be tested automatically. With respect to possible mechanical damages, an alert to RSD may triggered and an operator can be sent for checking for mechanical damages. This not only saves time but also supports a proactive maintenance strategy, where damaged coils are identified and addressed before they cause system failures or imaging errors. The integration of the controller further enables seamless monitoring and potential remote diagnostics, improving service response and reducing downtime while ensuring that only properly functioning coils are used in patient examinations.

According to an embodiment of the invention, the testing procedure comprises the following method steps:
returning the mass from the displacement position back into the retaining position,
automatically detecting whether the radio frequency coil is in good condition for further use or not and/or alerting remote service diagnostics for detecting whether the radio frequency coil is in good condition for further use or not,
switching to regular operation of the system when it was detected that the radio frequency coil is in good condition for further use,
or sending out an alert for replacing the radio frequency coil if it was detected that the radio frequency coil is not in good condition for further use.

It should be noted that in this embodiment, the steps of automatically detecting whether the radio frequency coil is in good condition for further use or not and alerting remote service diagnostics for detecting whether the radio frequency coil is in good condition for further use or not may be combined. This may be useful since automatic detection may be especially helpful for testing electric and electronic equipment while manual detection by an operator of remote service diagnostics may be more helpful for detecting mechanical damages.

The primary function of this embodiment is to provide an efficient way to verify the operational readiness of the RF coil, ensuring that any damage caused by mishandling is identified and addressed before it can impact the quality of diagnostic imaging or patient safety. The advantages of this embodiment include improved diagnostic reliability, operational efficiency, and safety. The ability to reset the sensor and test the coil before each use also supports predictive maintenance, helping to extend the coil's lifespan and improve the overall performance of the magnetic resonance examination system. This approach ensures a proactive, streamlined, and safe diagnostic process for both operators and patients.

According to an embodiment of the invention, the method comprises the further method step of
when it was detected that the radio frequency coil is not in good condition for further use, logging that the radio frequency coil experienced an invent that caused the mass to be displaced into the displacement position.

The primary function of this embodiment is to create a record of mishandling events. By logging each event, the system maintains a history of mishandling occurrences, which can be useful for analyzing recurring problems, identifying patterns, and determining the root causes of damage. The event log is valuable for both immediate troubleshooting and long-term performance tracking, enabling better service planning and reducing the likelihood of repeated damage.

The invention also relates to a computer program comprising instructions which, when the program is executed by a magnetic resonance examination system as described before, cause the system to carry out the steps of the method as described before.

The invention also relates to a computer-readable medium having stored thereon the computer program as described before.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1a schematically depicts a radio frequency coil with a sensor according to an embodiment of the invention with a mass in its retaining position,
Fig. 1b schematically depicts the radio frequency coil of Fig. 1a with the mass in its displacement position,
Fig. 2 schematically depicts a system with a magnetic resonance examination apparatus and a sensor according to an embodiment of the invention,

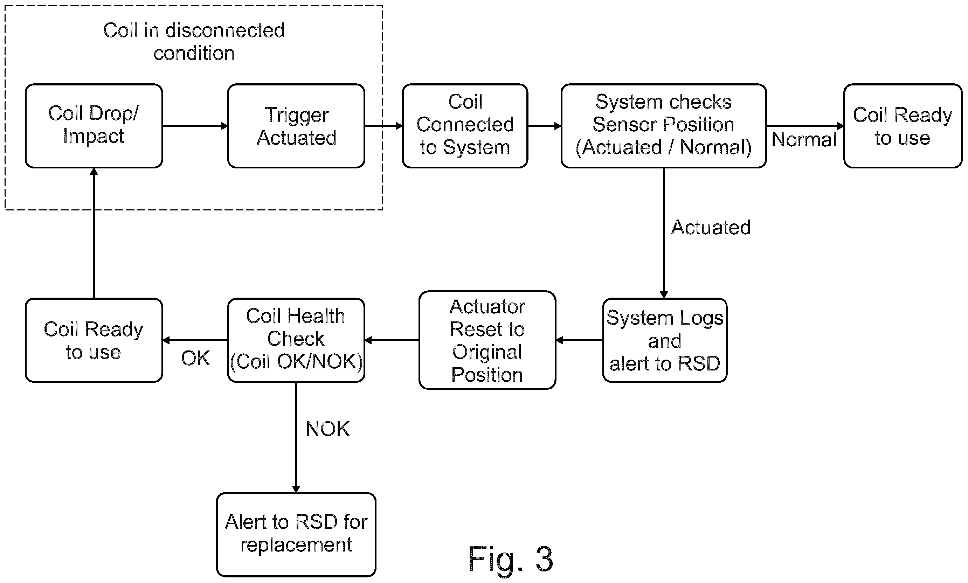

Fig. 3 depicts a method for operating the system of Fig. 2,
Fig. 4 schematically depicts a sensor according to an embodiment of the invention in more detail,
Fig. 5 schematically depicts a sensor arrangement according to an embodiment of the invention with three sensors,
Fig. 6 schematically depicts the mechanical retaining mechanism of the sensor of Fig. 4 in more detail, and
Fig. 7a schematically depicts the sensor of Fig. 4 with its mass in its retaining position,
Fig. 7b schematically depicts the sensor of Fig. 4 with its mass in its displacement position,
Fig. 8 a flowchart depicting a method according to an embodiment of the invention.

### DETAILED DESCRIPTION OF EMBODIMENTS

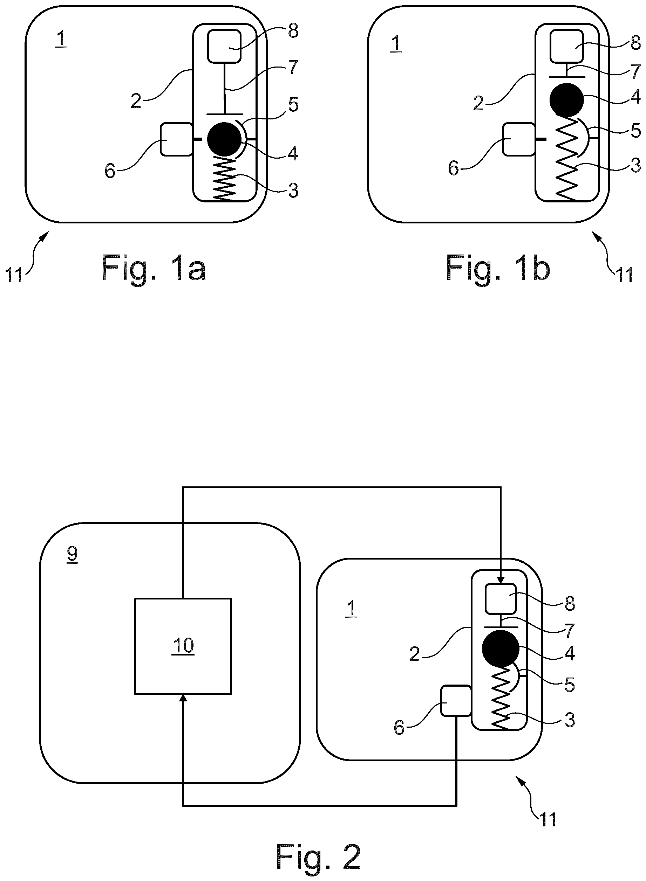

From Figs. 1a and 1b, a radio frequency coil 1 with a sensor 11 for detecting mishandling of the radio frequency coil 1 can be seen. The sensor 11 comprises a frame 2, a mechanical biasing element 3, a mass 4, and a mechanical retaining mechanism 5 for holding the mass 4 in a retaining position. The mechanical biasing element 3 is abutted to the frame 2 and is configured to exert a bias force on the mass 4, urging the mass 4 away from its retaining position into a displacement direction. The mechanical retaining mechanism 5 is configured to hold the mass 4 in the retaining position against the bias force of the mechanical biasing element 3 and to let the mass 4 displace from the retaining position in the displacement direction into a displacement position when an external force with a force component in the displacement direction exceeding a predetermined threshold is exerted on the mass 4 in addition to the bias force of the mechanical biasing element 3.

The mass 4 in the retaining position ensures that normal handling and routine usage of the RF coil do not trigger false alarms, while the mechanical biasing element 3 maintains a predefined sensitivity threshold that allows detection of only significant impacts or mishandling events. This functionality helps prevent unnecessary interruptions due to minor vibrations or normal movements, ensuring reliability and efficiency in clinical environments.

The sensor 11 further comprises a position detector 6, which is configured to detect whether the mass 4 has been displaced into the displacement position. The position detector 6 serves a critical function by providing an accurate and reliable indication of whether a significant impact has occurred. This embodiment eliminates the need for manual inspections and ensures that even subtle or repeated impacts are documented. As a result, operators or remote diagnostic systems can receive timely alerts regarding mishandling events, enhancing the overall reliability and performance of the magnetic resonance examination system.

In addition, the sensor 11 further comprises an electrical resetting mechanism 7, which is configured to return the mass 4 from the displacement position into the retaining position after displacement. The electrical resetting mechanism 7 minimizes operational delays by automatically resetting the sensor, ensuring it is always ready to monitor subsequent mishandling events without requiring manual intervention. The automatic reset capability reduces the risk of human error, such as operators forgetting to reset the sensor, which could otherwise result in undetected damage. This feature is particularly advantageous in clinical settings where operational readiness and continuous performance are essential.

As shown in Fig. 2, the electrical resetting mechanism 7 comprises a relay 8 for connecting to and being controlled by a magnetic resonance examination apparatus 9. The magnetic resonance examination apparatus 9 includes a controller 10 for managing the sensor 11 of the radio frequency coil 1. The relay 8 acts as a switch, allowing the magnetic resonance system to remotely trigger the resetting mechanism and return the mass 4 to its retaining position. This remote-control capability improves system efficiency by integrating the sensor reset process into routine maintenance and diagnostic procedures, minimizing disruptions and reducing service costs.

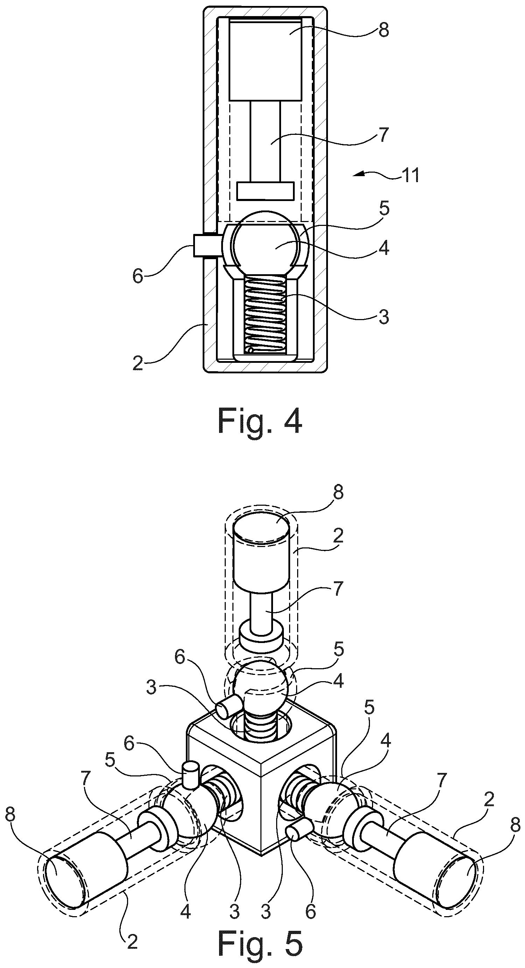

As shown in Fig. 4, the mass 4 can be a ball, and the mechanical retaining mechanism 5 can be an annular snap mechanism for holding the ball securely until a significant external force causes it to displace. The use of a ball as the mass provides consistent and predictable displacement behavior, ensuring accurate detection of mishandling events. The annular snap mechanism provides a secure yet releasable grip on the ball, reducing the likelihood of false triggering due to minor vibrations. This embodiment ensures high accuracy in detecting genuine impacts while minimizing maintenance requirements due to its simple, durable mechanical design.

Fig. 4 also shows that the mechanical biasing element 3 can be a spring, preferably made of brass or an MR-compatible plastic material. The spring continuously applies a bias force to the mass 4, ensuring that the mass remains securely held by the mechanical retaining mechanism under normal conditions. When an external force exceeding the threshold is applied, the spring allows the mass to displace, triggering the detection mechanism. The spring's simple and reliable mechanical action reduces power consumption and provides consistent force over time, ensuring long-term stability and accuracy of the sensor.

As shown in Fig. 5, a sensor arrangement with three sensors 11 is provided, wherein the displacement directions of the three sensors 11 all point in different directions, preferably orthogonal to each other. This configuration ensures that impacts or forces occurring from any direction in three-dimensional space are detected. Each sensor is sensitive to displacement along its respective axis (X, Y, or Z), allowing comprehensive monitoring of mishandling events regardless of their direction. This multi-directional capability ensures that even complex or angled impacts, such as when the coil is dropped or bumped at an angle, are reliably detected. By covering all possible directional impacts, this embodiment improves the system's ability to identify and respond to potential damage, thereby enhancing the overall protection and longevity of the RF coil.

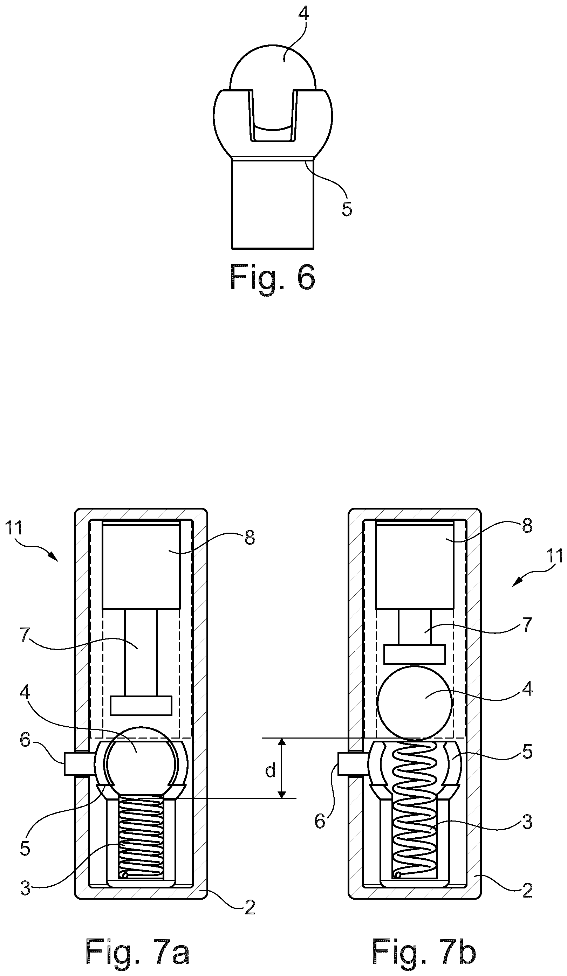

Fig. 6 provides a detailed view of the annular snap mechanism, showing how it securely holds the ball mass 4 until a significant external force is applied. The snap mechanism's precision ensures that only impactful events are detected, minimizing false alarms and enhancing the system's reliability in identifying genuine mishandling incidents. The use of MR-compatible materials, such as polycarbonate or acetal homopolymer resin (POM-H), ensures that the sensor does not interfere with the magnetic resonance imaging process while maintaining high durability.

The general method of operating the magnetic resonance examination system, comprising a radio frequency coil 1 and a magnetic resonance examination apparatus 9, includes the following as shown in Fig. 2:
When the radio frequency coil 1 is not connected to the magnetic resonance examination apparatus 9, i. e. when the radio frequency coil 1 is in disconnected condition, the sensor 11 (or a sensor arrangement of three sensors 11) provides for detecting a drop of or an impact on the radio frequency coil 1, step "Coil Drop / Impact". This results in a step "Trigger Actuated" in which the mass 4 is displaced from the retaining position into the displacement position due to the drop or impact.

Thereafter, the following method steps are performed:
1. "Coil Connected to System": This step includes sensing whether the radio frequency coil 1 is connected to the magnetic resonance examination system. This step ensures that the sensor's 11 status is monitored only when the coil 1 is actively in use with the magnetic resonances apparatus 9, preventing unnecessary diagnostics during storage or transport.
2. "System checks Sensor Position (Actuated/Normal)": In this step it is detected whether the mass 4 is held in the retaining position or was displaced into the displacement position: This step verifies whether a significant impact or mishandling event has occurred.
3. "Normal - Coil ready to use": This step includes switching to regular operation of the system when it is detected that the mass 4 is held in the retaining position.
4. "Actuated - System Logs and alert to RSD": This step includes an event log, including details such as time, date, and impact severity, helps in root cause analysis and future performance tracking. Further, an alert is sent to a remote service diagnostics.
5. "Actuator Reset to Original Position": This step includes resetting the sensor 11 automatically using the electrical resetting mechanism 7, ensuring that it is ready for future use.
6. "Coil Health Check (Coil OK/NOK)": This step includes a dynamical assessment of the integrity of the RF coil 1, ensuring that a damaged coil 1 does not compromise diagnostic quality. Hence, it is detected whether the radio frequency coil 1 is in good condition for further use or not: The system performs diagnostics to check for potential mechanical or electronic damage.
7. "NOK - Alert to RSD for replacement": This step includes sending out an alert for replacement if the coil 1 is not in good condition for further use. This ensures that a damaged coil 1 is identified and addressed before it cause imaging errors or system downtime.
8. "OK - Coil Ready to use": This step includes switching to regular operation when the coil is determined to be in good condition for further use.

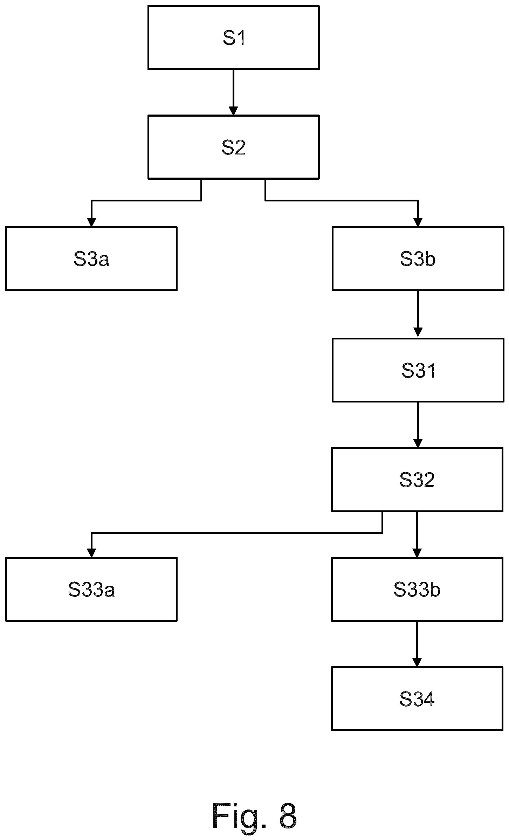

A possible method according to an embodiment of the invention is also shown in Fig. 8. This method comprises the following method steps:
S1: sensing whether the radio frequency coil 1 is connected to the magnetic resonance examination system,
S2: detecting whether the mass 4 is held in the retaining position or was displaced into the displacement position, and
S3a: switching to regular operation of the system when it was detected that the mass 4 is held in the retaining position, or
S3b: switching to a testing procedure when it was detected that the mass 4 was displaced into the displacement position,
S31: returning the mass 4 from the displacement position back into the retaining position,
S32: automatically detecting whether the radio frequency coil 1 is in good condition for further use or not and alerting remote service diagnostics for detecting whether the radio frequency coil 1 is in good condition for further use or not,
S33a: switching to regular operation of the system when it was detected that the radio frequency coil 1 is in good condition for further use, or
S33b: sending out an alert for replacing the radio frequency coil 1 if it was detected that the radio frequency coil 1 is not in good condition for further use, and
S34: when it was detected that the radio frequency coil 1 is not in good condition for further use, logging that the radio frequency coil 1 experienced an event that caused the mass 4 to be displaced into the displacement position.

The activation mechanism of the sensor 11 relies on the interaction between the spring load (force exerted by the mechanical biasing element 3) and the reaction force from an external impact or fall experienced by the radio frequency coil 1. Under normal conditions, the mass 4 experiences a preload force from the mechanical biasing element 3 that is carefully selected to ensure that the ball remains securely held within the annular snap mechanism. The spring preload force Fₛ is designed to be lower than the threshold force required to dislodge the ball F_{d}, thereby preventing false triggering during regular handling.

During a mishandling event, such as a fall or impact, an additional force Fᵢ is exerted on the coil 1, which is transmitted to the sensing mechanism. The combined force of the spring preload Fₛ and the impact force Fᵢ exceeds the dislodging force threshold F_{d}, causing the mass 4 to be displaced from its retaining position. The position detector 6 then detects this displacement and may signal a mishandling event.

The relationship between these forces can be described as F_{d} < Fₓ, and Fₓ = Fₛ + Fᵢ, wherein F_{d} is the force required to dislodge the ball from the annular snap mechanism, Fₓ is the total sensing force, i. e. the force sensed by the mass 4, wherein this total sensing force Fₓ is the sum of Fₛ, being the spring preload force, and Fᵢ, being the force due to an external impact.

Calculation of the impact force Fᵢ is as follows Fᵢ = E / x, wherein E is the kinetic energy of the impact with E = ½ m v², x is the distance over which the kinetic energy is applied, m is the mass of the impacting object, and v is the impact velocity.

Proper functionality of the sensing mechanism depends on the design of the annular snap mechanism and the selection of the spring. The snap mechanism is designed to securely hold the mass 4 under normal conditions and release it only when the combined sensing force Fₓ exceeds the dislodging threshold.

The selection of the spring is based on its preload force Fₛ and the required deflection d (depicted in Figs. 7a and 7b) to achieve the desired spring rate k. The preload force is set at approximately two-thirds of the total sensing force, i. e. Fs = 0.67 Fₓ, to balance sensitivity and robustness, ensuring that minor vibrations do not dislodge the ball while significant impacts are reliably detected. Then, the required spring rate k can be calculated as k = Fₛ / d.

### REFERENCE SYMBOL LIST

- 1: radio frequency coil
- 2: frame
- 3: mechanical biasing element
- 4: mass
- 5: mechanical retaining mechanism
- 6: position detector
- 7: electrical resetting mechanism
- 8: relay
- 9: magnetic resonance examination apparatus
- 10: controller
- 11: sensor

## Claims

1. Sensor (11) for a radio frequency coil (1), comprising:
a frame (2),
a mechanical biasing element (3),
a mass (4), and
a mechanical retaining mechanism (5) for holding the mass (4) in a retaining position, wherein
the mechanical biasing element (3) is abutted to the frame (2) and configured to exert a bias force on the mass (4), urging the mass (4) away from its retaining position into a displacement direction, and
the mechanical retaining mechanism (5) is configured to hold the mass (4) in the retaining position against the bias force of the mechanical biasing element (3) and to let the mass (4) displace from the retaining position in the displacement direction into a displacement position when an external force with a force component in the displacement direction exceeding a predetermined threshold is exerted on the mass (4) in addition to the bias force of the mechanical biasing element (3).

2. Sensor (11) according to claim 1, further comprising a position detector (6) which is configured for detecting whether the mass (4) has been displaced into the displacement position.

3. Sensor (11) according to claim 1 or 2, further comprising an electrical resetting mechanism (7) which is configured to return the mass (4) from the displacement position into the retaining position after displacement.

4. Sensor (11) according to claim 3, wherein the electrical resetting mechanism (7) comprises a relay (8) for connecting to and being controlled by a magnetic resonance examination apparatus (9).

5. Sensor (11) according to any one of the previous claims, wherein the mass (4) is a ball, and the mechanical retaining mechanism (5) is an annular snap mechanism for holding the ball.

6. Sensor (11) according to any one of the previous claims, wherein the mechanical biasing element (3) is a spring.

7. Sensor arrangement with three sensors (11) according to any one of the previous claims, wherein the displacement directions of the three sensors (11) all point into different directions.

8. Sensor arrangement according to claim 7, wherein the displacement directions of the sensors (11) are all perpendicular to each other.

9. Radio frequency coil (1), comprising a sensor (11) according to any one of claims 1 to 6 or a sensor arrangement according to claim 7 or 8.

10. Magnetic resonance examination system, comprising a radio frequency coil (1) according to claim 9 and a magnetic resonance examination apparatus (9) with a controller (10) for the sensor/sensors (11) of the radio frequency coil (1).

11. Method of operating a magnetic resonance examination system comprising a radio frequency coil (1) and a magnetic resonance examination apparatus (9), wherein
the radio frequency coil (1) comprises a sensor (11) with a mass (4) which is held in a retaining position against a bias force urging the mass (4) away from its retaining position into a displacement direction, wherein the mass (4) is displaced in the displacement direction into a displacement position when an external force with a force component in the displacement direction exceeding a predetermined threshold is exerted on the mass (4) in addition to the bias force,
the method comprising the following method steps:
S1: sensing whether the radio frequency coil (1) is connected to the magnetic resonance examination system,
S2: detecting whether the mass (4) is held in the retaining position or was displaced into the displacement position, and
S3a: switching to regular operation of the system when it was detected that the mass (4) is held in the retaining position, or
S3b: switching to a testing procedure when it was detected that the mass (4) was displaced into the displacement position.

12. Method according to claim 11, wherein the testing procedure comprises the following method steps:
S31: returning the mass (4) from the displacement position back into the retaining position,
S32: automatically detecting whether the radio frequency coil (1) is in good condition for further use or not and/or alerting remote service diagnostics for detecting whether the radio frequency coil (1) is in good condition for further use or not,
S33a: switching to regular operation of the system when it was detected that the radio frequency coil (1) is in good condition for further use, or
S33b: sending out an alert for replacing the radio frequency coil (1) if it was detected that the radio frequency coil (1) is not in good condition for further use.

13. Method according to claim 11 or 12, comprising the further method step of
S34: when it was detected that the radio frequency coil (1) is not in good condition for further use, logging that the radio frequency coil (1) experienced an event that caused the mass (4) to be displaced into the displacement position.

14. Computer program comprising instructions which, when the program is executed by a magnetic resonance examination system according to claim 10, cause the system to carry out the steps of the method according to any one of claims 11 to 13.

15. Computer-readable medium having stored thereon the computer program of claim 14.
